# EUROPEAN PATENT APPLICATION

(11) **EP 4 844 416 A1**
(43) Date of publication of application: **25.11.2026**
(21) Application number: 26174751.3
(22) Date of filing: 27.04.2026
(51) Int. Cl.: G01R 19/25, B60L 3/00, G01R 31/28, G01R 1/20, G01R 19/00, G01R 31/36, G01R 31/3832, G01R 35/00

(54) **METHOD OF MEASURING A CURRENT AND CORRESPONDING CIRCUIT**

(30) Priority: 21.05.2025 IT 202500011503
(71) Applicant: STMicroelectronics International N.V., 1228 Plan-les-Ouates, Geneva (CH)
(72) Inventor: D'ANGELO, Vittorio, I-84015 Nocera Superiore (Salerno) (IT); CANNAVACCIUOLO, Salvatore, I-80010 Villaricca (Napoli) (IT); MIGLIERINA, Riccardo, I-27010 Borgarello (Pavia) (IT); BUCCOLIERO, Simone, I-20144 Milano (IT); CANNONE, Alessandro, I-20017 Rho (Milano) (IT)
(74) Representative: Buzzi, Notaro & Antonielli d'Oulx S.p.A.

(57) **Abstract**

A method of measuring a current (Iₘₑₐₛ), comprising:
sensing said current (Iₘₑₐₛ) via a first analog-to-digital converter (ADC₁) in a time instant, obtaining a first digital value;
sensing said current (Iₘₑₐₛ) via a second analog-to-digital converter (ADC₂) in said time instant, obtaining a second digital value;
computing (CC) an absolute difference between the first digital value and the second digital value;
comparing (CC) said absolute difference with a threshold; and
if the absolute difference is higher than the threshold, detecting the presence of an anomaly;
wherein said threshold is:
a constant value for current (Iₘₑₐₛ) values below a current threshold; and
a value that increases proportionally to the current (Iₘₑₐₛ) for current (Iₘₑₐₛ) values above said current threshold.

## Description

### Technical field

The description relates to methods for performing measurements of a current in safety-related applications or safety-critical applications, such as BMS ("Battery Management System").

One or more embodiments relate to methods for performing such measurements in safety-related applications with the aim of increasing the reliability of such measurements.

### Background

In safety-critical (or safety-related) applications, sensor data is to be acquired with high reliability in order to prevent safety-related issues.

In addition, many safety-critical applications have to satisfy safety standard requirements, such as high ratings of SIL ("Safety Integrity Level") or ASIL ("Automotive Safety Integrity Level") in automotive applications, on sensor monitoring functions, in order to meet FSR ("Functional Safety Requirements") and SG ("Safety Goal") requirements.

To improve the reliability of measured data, for instance, of a current that is to be measured, known solutions measure such data via a plurality of sensors, therefore, adding at least one sensor and at least one redundant component. Usually, a first current measure is obtained via a first sensor at a certain time instant, and a second redundant current measure is obtained via a second redundant sensor at the same time instant.

The first measure is then compared with the second redundant measure in order to verify whether the sensors are providing a same result for a same measuring operation.

Known solutions use such redundancy to compute an absolute difference between the first measure and the second redundant measure, and then to compare such difference with a fixed threshold indicative of an accepted margin between the two measures.

If the absolute difference is below the fixed threshold, known solutions consider that the sensors are measuring a same quantity, therefore, the safety-critical application can operate normally.

Otherwise, if the absolute difference is above the fixed threshold, known solutions consider that the sensors are measuring different quantities, therefore, an anomaly is present in the operation of the safety-critical application.

For instance, in known BMS ("Battery Management System") applications, the concept of redundancy and diversity is exploited by adding an external operational amplifier to sense pack current via a shunt resistor or a cell voltage and a redundant operational amplifier to sense a redundant value of the pack current.

Solutions to increase even more the reliability of the measuring operations in safety-critical applications would therefore be beneficial.

### Object and summary

An object of one or more embodiments is to contribute in providing solutions that increase the reliability of the measuring operations with respect to those performed by the known solutions described.

According to one or more embodiments, that object is achieved via a method having the features set forth in the claims that follow.

One or more embodiments concern a corresponding circuit.

The claims are an integral part of the technical teaching provided in respect of the embodiments.

Solutions as described herein include a method of measuring a current, comprising:
sensing said current via a first analog-to-digital converter in a time instant, obtaining a first digital value;
sensing said current via a second analog-to-digital converter in said time instant, obtaining a second digital value;
computing an absolute difference between the first digital value and the second digital value;
comparing said absolute difference with a threshold; and
if the absolute difference is higher than the threshold, detecting the presence of an anomaly;
wherein said threshold is:
   a constant value for current values below a current threshold; and
   a value that increases proportionally to the current for current values above said current threshold.

In various embodiments, said method is performed in a battery management system, BMS, said first analog-to-digital converter and said second analog-to-digital converter being comprised in the battery management system.

In various embodiments, one analog-to-digital converter between the first analog-to-digital converter and the second analog-to-digital converter is configured to perform additional functions in the battery management system.

In various embodiments, said analog-to-digital converter configured to perform additional functions in the battery management system is a coulomb counter of the battery management system or an analog-to-digital converter of the battery management system configured to monitor an instantaneous battery pack current.

In various embodiments, said constant value of the threshold is equal to the higher noise floor between the noise floor of the first analog-to-digital converter and the one of the second analog-to-digital converter.

In various embodiments, said current threshold is the current obtained by intersecting the higher noise floor between the noise floor of the first analog-to-digital converter and the one of the second analog-to-digital converter with an ideal error transfer function of an analog-to-digital converter.

In various embodiments, said first analog-to-digital converter and said second analog-to-digital converter are not synchronous, said first analog-to-digital converter having a first analog-to-digital converter transfer function and said second analog-to-digital converter having a second analog-to-digital converter transfer function;
said method comprising:
filtering, via a first filtering unit having a first filtering transfer function, said first digital value, obtaining a first filtered digital value;
filtering, via a second filtering unit having a second filtering transfer function, said second digital value, obtaining a second filtered digital value; and
performing said operation of computing the absolute difference between the first filtered digital value and the second filtered digital value;
wherein a combination of the first analog-to-digital converter transfer function and the first filtering transfer function is equal to a combination of the second analog-to-digital converter transfer function and the second filtering transfer function.

In various embodiments, the method comprises matching the combination of the first analog-to-digital converter transfer function and the first filtering transfer function to the combination of the second analog-to-digital converter transfer function and the second filtering transfer function by:
selecting a subset of the first filtering unit and/or the second filtering unit to perform the respective filtering operation; and/or
modifying filtering parameters of one filtering unit between the first filtering unit or the second filtering unit.

In various embodiments, said method is performed in response to the reception of a command of a control unit indicating to measure the current;
wherein said method comprises:
in response to said control unit being in a sleep mode, automatically performing, preferably periodically, the measuring of the current; and
if the presence of an anomaly is detected, sending a wake-up signal to the control unit indicating said presence of the anomaly.

Solutions as described herein facilitate achieving a higher reliability of the measuring operations performed than known solutions.

### Brief description of the figures

One or more embodiments will now be described, by way of example only, with reference to the annexed figures, wherein:
Figure 1 illustrates a measuring unit according to embodiments of the present description;
Figure 2 illustrates a first exemplary implementation of a measuring unit comprising a first and a second ADC ("Analog-to-Digital Converter") according to embodiments of the present description;
Figure 3 illustrates a diagram showing the states of the first and the second ADC of Figure 2 according to embodiments of the present description;
Figure 4 illustrates a second exemplary implementation of a measuring unit comprising a first and a second ADC ("Analog-to-Digital Converter") according to embodiments of the present description;
Figure 5 illustrates a diagram showing the states of the first and the second ADC of Figure 4 according to embodiments of the present description; and
Figure 6 illustrates a BMS according to solutions as described herein.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As previously described, solutions as described herein aim at obtaining higher measurement reliability in safety-critical applications.

Specifically, solutions according to the present description refer to BMS ("Battery Management System") applications. For example, solutions according to the present description may be used in BMS for Energy Storage Systems (ESS) or automotive.

However, it is noted that although the present description refers to solutions for use in BMS, solutions as described herein may also be considered in any other safety-critical application wherein a measurement requiring a certain safety rating, such as SIL or ASIL, is requested.

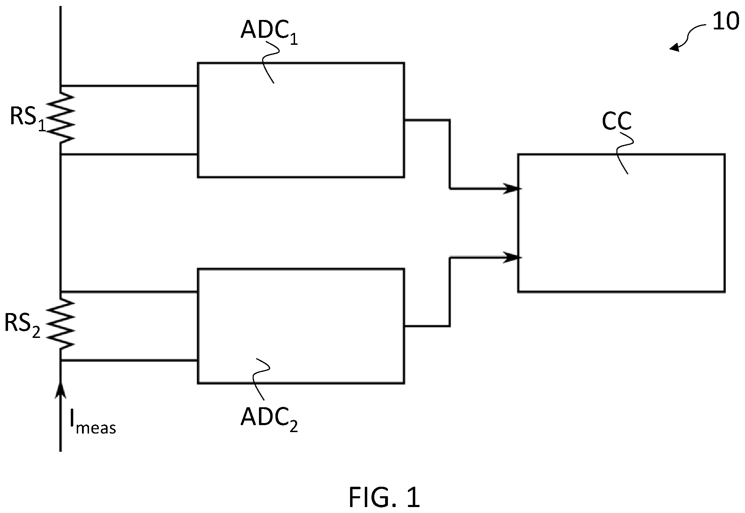

Figure 1 illustrates a measuring unit 10 according to embodiments of the present description.

The measuring unit 10 of Figure 1 comprises:
a first ADC ("Analog-to-Digital Converter") ADC₁ configured to sense a certain analog quantity, for instance a first voltage resulting from a current Iₘₑₐₛ (corresponding to a current to be measured) flowing in a first shunt resistor RS₁, and to convert the analog quantity into a first digital value;
a second (redundant) Analog-to-Digital Converter ADC₂ configured to sense again such analog quantity, for instance a second voltage resulting from such current Iₘₑₐₛ flowing in a second shunt resistor RS₂ dimensioned as the first shunt resistor RS₁, and to convert such analog quantity into a second digital value; and
a cross-check unit CC configured to receive the output values provided by the first ADC and the second ADC, that is, the first digital value and the second digital value respectively, and to perform a conversion integrity check.

It is noted that the first shunt resistor RS₁ and the second shunt resistor RS₂ may also be implemented via a same shunt resistor, coupled to both the first ADC and the second ADC.

It is noted that the sensing of the analog quantity by the first ADC and the one by the second ADC are performed at a same time instant. If the first ADC and the second ADC are asynchronous, that is, have different timings such as different clocks or different conversion times, the measurements (performed at the same time instant) may be aligned before entering the cross-check unit CC.

The conversion integrity check operation according to solutions as described herein is performed by comparing a first output conversion provided by the first ADC (that is, the first digital value) with a second (redundant) output conversion provided by the second ADC (that is, the second digital value) to verify whether such first output conversion corresponds to the second (redundant) output conversion.

In fact, in case of absence of hardware failures, the first output conversion provided by the first ADC and the second (redundant) output conversion provided by the second ADC should be equivalent, except for a margin related to the ADC accuracy due to differences/mismatches and noise.

Such comparison is performed by computing an absolute difference between the two conversions provided by the first and the second ADC, and by comparing such absolute difference with a digital threshold indicative of an accepted margin between the two measures.

If the absolute difference between the two conversions is higher than the digital threshold indicative of the accepted margin between the measures, solutions according to the present description are configured to detect an anomaly in the behavior of the analog quantity that is to be measured.

In solutions according to the present description, the cross-check unit CC may be configured to run a self-test procedure in order to evaluate its correct functionality. In this way, it is possible to understand if the anomaly is due to the cross-check unit CC itself or if the behavior of the analog quantity that is to be measured is anomalous.

It is noted that, differently from the known solutions described above, solutions according to the present description consider a digital threshold having a variable value, facilitating achieving a higher reliability.

The value of the digital threshold according to solutions as described herein can be obtained as a function of the value of the measured quantity, for instance, as a function of the value of the current Iₘₑₐₛ that is to be measured.

Therefore, the value of the digital threshold may:
be constant, for values of the measured analog quantity which are smaller than or equal to a quantity threshold; and
increase of an amount proportional to the value of the measured analog quantity, for values of the measured quantity which are higher than such quantity threshold.

The quantity threshold may be chosen aiming at reducing the influences of the offset and gain errors of the first and second ADC on the measurements.

In fact, in correspondence of small values of the measured quantity (that is, of the current Iₘₑₐₛ), the offset error of the ADCs alters the measurements of the analog quantity more than the gain error, therefore, such offset error is to be considered when performing the comparison operation with the variable digital threshold described above.

Hence, in order to consider the offset (constant) error, the value of the variable digital threshold is set, for values of the measured quantity lower than or equal to the quantity threshold, to a constant value, for instance, equal to the noise floor of the ADC.

It is noted that such noise floor corresponds to the maximum power of the random noise affecting the ADC outputs.

Conversely, in correspondence of higher values of the measured quantity, the gain error of the ADCs alters the measurements of such analog quantity more than the offset error, therefore, such gain error is to be considered when checking whether the first output conversion provided by the first ADC is within the value of the variable digital threshold from the second (redundant) output conversion provided by the second ADC.

Hence, in order to consider the gain error (that increases with the increasing of the measured value), the value of the variable digital threshold is increased, for values of the measured quantity higher than the quantity threshold, of a value that increases proportionally to the value of the measured quantity. It is noted that, by increasing the variable digital threshold for higher values of the measured quantity, it is possible to prevent in a more efficient way the notification of false positives, that is, of detected malfunctioning in the operation of the safety-critical application not due to actual problems but to the presence of the gain error of the ADC.

In addition, since the gain error is already considered by increasing the variable digital threshold in correspondence of high values of the measured quantity, the value of the variable digital threshold for smaller values of the measured quantity, when the offset error has a greater impact than the gain error, may be smaller than in known solutions, for instance, may be equal to the noise floor of the ADC. In fact, in known solutions, since a single fixed-value threshold is considered, such a threshold is to be chosen by considering a tradeoff between the impacts of the offset error and those of the gain error, leading to false positives for high values of the measured quantity and to a lower accuracy for small values of such measured quantity.

To summarize, solutions according to the present description refer to a method of measuring an analog quantity such as a current Iₘₑₐₛ, such method comprising:
sensing such current Iₘₑₐₛ via a first analog-to-digital converter ADC₁ in a time instant, obtaining a first digital value;
sensing such current Iₘₑₐₛ via a second analog-to-digital converter ADC₂ in such time instant, that is, contemporaneously to the sensing operation of the first ADC, obtaining a second digital value;
computing, for instance, via the cross-check unit CC, an absolute difference between the first digital value and the second digital value;
comparing, for instance, again via the cross-check unit CC, such absolute difference with a threshold, that is, the variable digital threshold described above; and
if the absolute difference is higher than the threshold, detecting the presence of an anomaly.

The threshold, that is, the variable digital threshold, considered in solutions as described herein is:
a constant value for current values below a current threshold, that is, the quantity threshold described above; and
a value that increases proportionally to the current Iₘₑₐₛ, for instance, a value that increases with the increasing of the current Iₘₑₐₛ, for current values above such current threshold.

In solutions according to the present description, such constant value of the threshold may be equal to the higher noise floor between the noise floor of the first analog-to-digital converter ADC₁ and the one of the second analog-to-digital converter ADC₂.

In view of the above, it is noted that the quantity threshold may be set in a point where the impact of the offset error and the one of the gain error are (about) equal. Therefore, such quantity threshold may be set in a point of intersection of a constant curve indicative of the noise floor of the ADC and an ideal characteristic curve indicative of the ideal behavior of the ADC.

Hence, for small values of the measured quantity, that is, for values of the measured quantity which are smaller than or equal to the quantity threshold described above, the digital threshold used in the comparison of the first output conversion provided by the first ADC and the second (redundant) output conversion provided by the second ADC is constant and equal to the noise floor of the ADC.

Differently, for higher values of the measured quantity, that is, for values of the measured quantity which are higher than the quantity threshold described above, the digital threshold used in the comparison of the first output conversion provided by the first ADC and the second (redundant) output conversion provided by the second ADC increases, starting from the noise floor of the ADC, proportionally with respect to increases of the value of the measured quantity.

Hence, the current threshold (corresponding to the quantity threshold described above) may be the current obtained in correspondence of the intersection between the higher noise floor between the noise floor of the first analog-to-digital converter ADC₁ and the one of the second analog-to-digital converter ADC₂ with an ideal error transfer function of an analog-to-digital converter.

For instance, if the absolute value of both of the two conversions provided by the first and the second ADC are higher than the quantity threshold, the following equations for obtaining the digital threshold *Th_{dgt}* may be considered: ${Th}_{dgt} = \frac{\left|{I}_{ADC 1}\right|}{{C}_{HI}} if \left|{I}_{ADC 1}\right| \geq \left|{I}_{ADC 2}\right| , obtaining \left|{I}_{ADC 1}-{I}_{ADC 2}\right| \leq \frac{\left|{I}_{ADC 1}\right|}{{C}_{HI}}$ ${Th}_{dgt} = \frac{\left|{I}_{ADC 2}\right|}{{C}_{HI}} if \left|{I}_{ADC 1}\right| < \left|{I}_{ADC 2}\right| , obtaining \left|{I}_{ADC 1}-{I}_{ADC 2}\right| \leq \frac{\left|{I}_{ADC 2}\right|}{{C}_{HI}}$ wherein:
*I*_{*ADC*1} is the quantity, that is, the current, sensed by the first ADC at a given time instant;
*I*_{*ADC*2} is the quantity, that is, the current, sensed by the second ADC at the same given time instant; and
*C_{HI}* is a constant having a pre-determined value indicative of the proportionality between the digital threshold and the highest measured analog quantity between *I*_{*ADC*1} and *I*_{*ADC*2}.

For instance, if at least one absolute value of the two conversions provided by the first and the second ADC is smaller than or equal to the quantity threshold, the following equations for obtaining the digital threshold *Th_{dgt}* may be considered: ${Th}_{dgt} = {C}_{LO} , obtaining \left|{I}_{ADC 1}-{I}_{ADC 2}\right| \leq {C}_{LO}$ wherein *C_{LO}* is a constant having a pre-determined value, for instance, a constant equal to the higher noise floor between the noise floor of the first ADC and the noise floor of the second ADC.

Moreover, in BMS applications or in applications wherein an analog-to-digital converter is already available, it would be advantageous to perform the measurements described above with a reduced area, for instance, providing only one additional analog-to-digital converter instead of the first ADC and the second ADC and exploiting the analog-to-digital converter already present in the system.

In this regard, it is noted that known solutions require a consistent increase in die area to provide a sensor (used to perform sensing operations) and the corresponding redundant sensor (that is, the redundant external operational amplifier used to perform redundant sensing operations) for measuring the analog quantity, also leading to higher power consumption for implementing and using such redundant structures.

Therefore, it would be advantageous to obtain the higher measurement reliability described above requested in safety-critical applications, for instance, the same (A)SIL rating obtained by solutions described above, with limited area increase and design efforts on the die, for instance, removing such redundant external operational amplifier. In this way, it is also possible to reduce production costs, maintaining the same (A)SIL rating.

In fact, such redundant component added in known solutions to measure data is only aimed at improving the reliability of such measurements, increasing the safety mechanism coverage. However, the redundant component of known solutions has the effect of increasing the area of the die, the amount of material requested (also called "Bill of Materials" - BOM), the costs, and power consumption.

Instead of the redundant component added in known solutions, solutions according to the present description can advantageously consider the use of an analog-to-digital converter already present, for instance, in the considered BMS system, that is, an analog-to-digital converter present in the system and configured to perform additional functions in such system.

Therefore, in solutions according to the present description:
the first ADC ("Analog-to-Digital Converter") ADC₁ may be added to the system in order to sense, for instance, continuously, the quantity to be measured (that is, the current Iₘₑₐₛ); and
the second (redundant) Analog-to-Digital Converter ADC₂ may be an analog-to-digital converter of a different type and already comprised in the considered system, normally configured to perform a different function but used, upon request, to measure the quantity (such as the current Iₘₑₐₛ) at the same time instant of the first ADC.

For instance, if BMS applications are considered, the second (redundant) Analog-to-Digital Converter ADC₂ already comprised in the BMS may be the Coulomb counter, which is normally configured to measure the state of charge of the battery.

It is noted that, if the second (redundant) Analog-to-Digital Converter ADC₂ is an analog-to-digital converter of a different type already comprised in the considered system and configured to perform additional functions therein, the first ADC and the second ADC may be asynchronous, that is, may have different timings such as different clock signals and/or different conversion times. Therefore, the signals provided to the cross-check unit CC are to be synchronized in order to be related to a same time window before the conversion integrity check is performed.

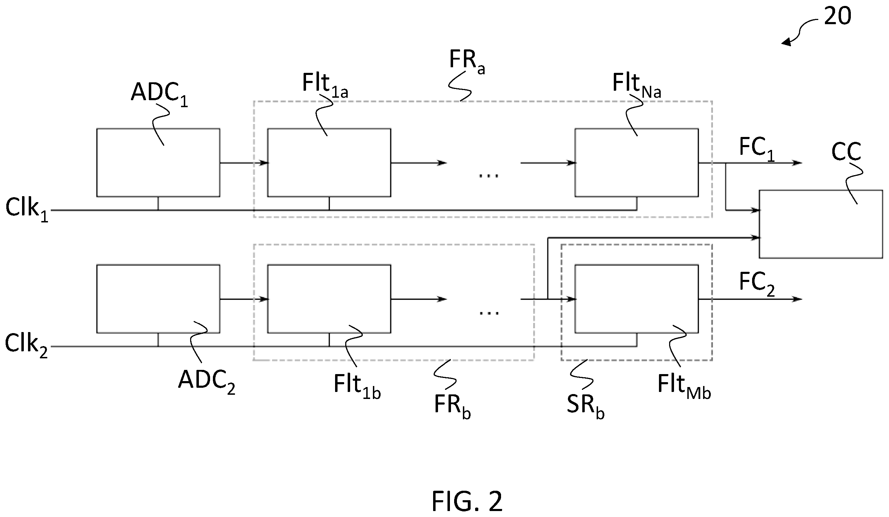

It is noted that, in the exemplary scenarios of Figures 2 to 5, the first ADC may provide a filtered digital conversion FC₁ of the analog quantity faster than the second ADC FC₂. Solutions with a second ADC faster than the first ADC may also be considered, for instance, switching the functions performed by the ADCs described in the following and maintaining a same transfer function as specified in the following description of Figure 2.

It is noted that the first ADC and the second ADC may have different clocks Clk₁ and Clk₂ respectively. In addition, the first ADC and the second ADC may have different conversion times.

A possible problem that can arise from the use of different ADCs may be related to the synchronization of the measurements performed by such ADCs, which are to be configured in order to sense the same quantity (that is, the same current Iₘₑₐₛ) at the same time instant.

Figure 2 illustrates a first exemplary implementation 20 of a measuring unit comprising a first ADC₁ and a second ADC₂ Analog-to-Digital Converter of different type as described above, according to embodiments of the present description.

It is noted that ADCs, in embodiments according to the present description, may be implemented via Sigma-Delta modulators.

Figure 2 illustrates a plurality of modular cascaded noise filters Flt placed at the output of the ADCs, that is, of the first ADC having a first clock Clk₁ and the second ADC having a second clock Clk₂, in order to provide a filtered digital conversion, FC₁ and FC₂ respectively, of the analog input. Such noise filters are configured to filter the noise of the digital signals provided as output by the ADCs, introducing a certain delay.

It is noted that the filters comprised in the plurality of modular cascaded filters Flt may be different from each other.

For instance, if the ADCs are implemented via Sigma-Delta modulators, the filters may be configured to provide an average of the measurements provided as output by the Sigma-Delta in order to remove noise.

For instance, a plurality of cascaded filters FRₐ having a fast data rate, for instance, comprising N filters Flt₁ₐ to Flt_{Na}, may be placed at the output of the first ADC. The output of the last filter of the plurality of cascaded filters FRₐ, for instance, the filter Flt_{Na} in Figure 2, may be coupled to a first input terminal of the cross-check unit CC in order to provide to the cross-check unit CC the first digital value.

Similarly, a plurality of cascaded filters comprising, for instance, M filters divided in a set of filters FR_{b} having a fast data rate (comprising, for example, the filter Flt_{1b} of Figure 2) and a set of filters SR_{b} having a slow data rate (comprising, for example, the filter Flt_{Mb} of Figure 2), may be placed at the output of the second ADC.

It is noted that the number N of filters comprised in the plurality of cascaded filters related to the first ADC and the number M of filters comprised in the plurality of cascaded filters related to the second ADC may be either equal or different from each other.

In order to synchronize the filtered digital conversion FC₁ provided, after a certain filtering delay:
by the last filter Flt_{Na} of the plurality of cascaded filters FRₐ placed at the output of the first ADC, and
to the first input terminal of the cross-check unit CC,
with the digital conversion of the second ADC, eventually filtered, it is possible to couple the second input terminal of the cross-check unit CC with the filter of the plurality of cascaded filters FR_{b} and SR_{b} that allows to obtain the same filtering delay of the filtered digital conversion FC₁ related to the first ADC, in order to perform the sensing operation over a same time window, obtaining a same data rate.

Therefore, the second input terminal of the cross-check unit CC is coupled to the output of the filter of the plurality of cascaded filters FR_{b} and SR_{b} related to the second ADC in order to obtain the same transfer function between:
the first ADC and the first input terminal of the cross-check unit CC; and
the second ADC and the second input terminal of the cross-check unit CC.

For instance, the second input terminal of the cross-check unit CC may be coupled to an intermediate filter of the plurality of cascaded filters FR_{b} and SR_{b} related to the second ADC.

In the exemplary scenario 20 of Figure 2, the same transfer function between the cross-check unit CC and the first ADC and the second ADC can be obtained, for example, by coupling the second input terminal of the cross-check unit CC to the last filter of the set of filters FR_{b} having a fast data rate.

Therefore, in solutions according to the present description, the first analog-to-digital converter ADC₁ and the second analog-to-digital converter ADC₂ may not be synchronous. For instance, the first analog-to-digital converter ADC₁ may have a first analog-to-digital converter transfer function and the second analog-to-digital converter ADC₂ may have a second analog-to-digital converter transfer function.

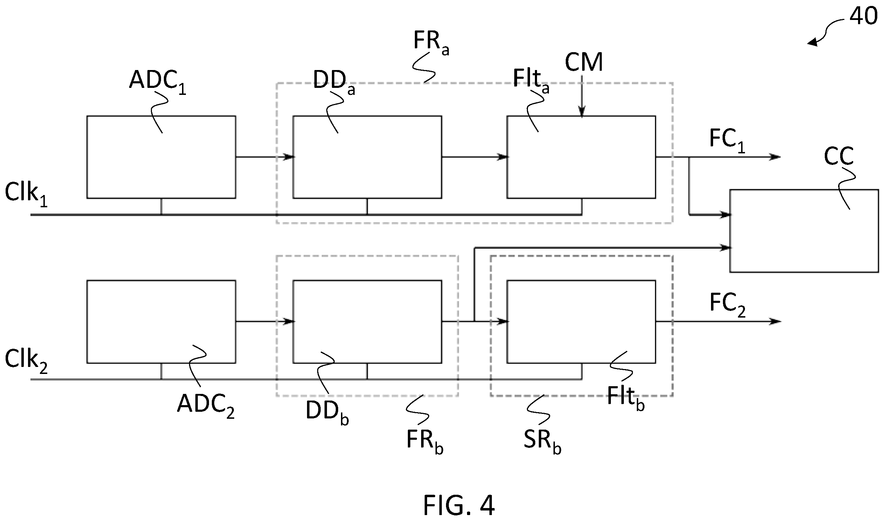

In this case, methods according to the present description may comprise:
filtering, via a first filtering unit, for instance, corresponding to the plurality of cascaded filters FRₐ having a fast data rate illustrated in Figures 2 and 4, having a first filtering transfer function, such first digital value, obtaining a first filtered digital value;
filtering, via a second filtering unit, for instance, corresponding to the plurality of cascaded filters comprising a set of filters FR_{b} having a fast data rate and a set of filters SR_{b} having a slow data rate illustrated in Figures 2 and 4, having a second filtering transfer function, such second digital value, obtaining a second filtered digital value; and
performing such operation of computing, for example, via the cross-check unit CC, the absolute difference between the first filtered digital value and the second filtered digital value.

It is noted that, in such a case, a combination of the first analog-to-digital converter transfer function and the first filtering transfer function is equal to a combination of the second analog-to-digital converter transfer function and the second filtering transfer function. Hence, the application of the first analog-to-digital converter transfer function and the first filtering transfer function to the current Iₘₑₐₛ is equal to applying the second analog-to-digital converter transfer function and the second filtering transfer function to such current Iₘₑₐₛ.

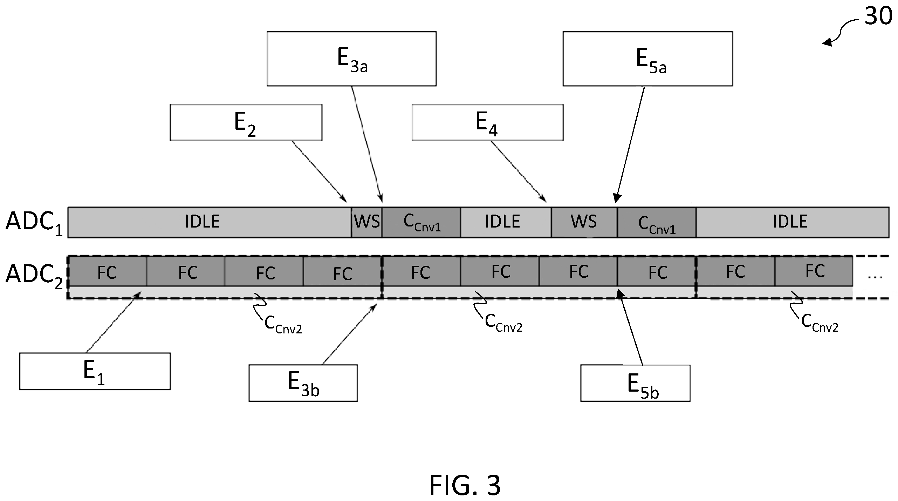

Figure 3 illustrates an exemplary diagram 30 showing the states of the first ADC₁ and the second ADC₂ analog-to-digital converters of Figure 2, according to embodiments of the present description.

For example, if the second ADC corresponds to the Coulomb counter of a BMS, such second ADC may be running continuously, performing a sequence of fast conversions FC. For instance, the first event E₁ in Figure 3 indicates the end of a first fast conversion FC, and four fast conversions FC provide E_{3b} a complete conversion C_{Cnv2} of the sensed analog quantity.

Differently, the conversions performed by the first ADC may be activated via a control unit, for instance, an external microcontroller, configured to send to the digital filters Flt of the first ADC and/or to the first ADC itself a signal that requests to perform a measuring operation.

In embodiments of the present description, such signal may comprise a time indication which can be used by the first ADC to synchronize its measuring operation with the one of the second ADC in order to evaluate the same time window during a conversion. Otherwise, such synchronization requested for evaluating the same time window during a conversion may be performed via other units or by the first ADC itself.

For instance, during the operation of the second ADC, the first ADC may be in an idle state IDLE. In response to the reception of the signal from the control unit, for instance, in correspondence of a second event E₂ in Figure 3, the first ADC enters into a wait state WS wherein such first ADC waits before sensing the quantity to be measured in order to be synchronized with a next fast conversion FC of the second ADC. Therefore, such wait state WS is used to wait for a synchronization between the first ADC and the second ADC.

In fact, it is noted that in the exemplary scenario of Figures 2 and 3, a complete conversion of the first ADC FC₁ is obtained via a transfer function that is equal to the transfer function of a fast conversion FC of the second ADC.

Then, in the same time instant, both the first ADC (in the event E₃ₐ) and the second ADC (in the event E_{3b}, in correspondence of an end of a previous complete conversion C_{Cnv2}) are configured to sense the quantity to be measured (for instance, the current Iₘₑₐₛ).

Therefore, the events E₃ₐ (happening after the wait state WS) and E_{3b} are performed in correspondence of the same time instant, thus, corresponding to a time instant where the synchronization between the first ADC and the second ADC is obtained in order to have the same transfer function at the inputs of the cross-check unit CC as described above.

The first ADC may be configured to end the conversion after a smaller delay C_{Cnv1}, providing the filtered digital conversion FC₁ to the cross-check unit CC. The second ADC, which, in the exemplary scenario of Figure 2 and 3, is slower than the first ADC, may provide to the cross-check unit CC an intermediate result of the filters Flt as described above. In the exemplary scenario of Figure 3, the cross-check unit CC may receive the conversion of the second ADC after the first fast conversion FC (having the same transfer function and considering the same time window of the first ADC complete conversion C_{Cnv1}), without waiting for the end of the complete conversion C_{Cnv2}.

After the end of the conversion C_{Cnv1}, the first ADC may return in an IDLE state, waiting for another reception of the signal from the control unit CU.

Upon reception of a second signal indicating to perform a measuring operation, the steps previously described are repeated in the events:
E₄, corresponding to such reception of the signal sent by the control unit CU by the first ADC (in embodiments such signal may comprise a time indication related to the next beginning of a fast conversion FC of the second ADC as described above);
E₅ₐ, corresponding to the sensing operation performed by the first ADC in correspondence of the time instant where the synchronization between the first ADC and the second ADC happens; and
E_{5b}, corresponding to the sensing operation performed by the second ADC in correspondence of such time instant where the synchronization between the first ADC and the second ADC happens.

It is noted that such event E_{5b} corresponds to a sensing operation performed by the second ADC in the last fast conversion FC of the complete conversion C_{Cnv2} (that is, the next fast conversion FC that is performed by the second ADC), in fact, such sensing operation is performed at the same time of the sensing of the first ADC and such last fast conversion FC has the same transfer function used to obtain the conversion of the first ADC.

Figure 4 illustrates a second exemplary implementation 40 of a measuring unit comprising a first ADC₁ and a second ADC₂ Analog-to-Digital Converter of different type as described above, according to embodiments of the present description.

It is noted that parts, elements, and/or components which have already been described with reference to Figure 2 are denoted by the same references previously used in such figure. Therefore, the description of such previously described parts, elements, and/or components will not be repeated in the following in order not to overburden the present description.

In solutions according to the present description, for instance, in the exemplary embodiment of Figure 4, it may not be possible to select the outputs of filters FR or SR to be coupled to the cross-check unit CC in order to obtain the same transfer function at both its input terminals.

For instance, the plurality of cascaded filters FRₐ having a fast data rate placed at the output of the first ADC may comprise:
a digital decimator DDₐ configured to reduce the sampling rate of the analog quantity to be measured; and
a low pass filter (LPF) Fltₐ.

Similarly, the plurality of cascaded filters comprising, for instance, filters divided in a set of filters FR_{b} having a fast data rate and a set of filters SR_{b} having a slow data rate may comprise:
a digital decimator DD_{b} having a fast data rate (thus, comprised in the set of filters FR_{b}), configured to reduce the sampling rate of the analog quantity to be measured; and
a low pass filter (LPF) Flt_{b} having a slow data rate (thus, comprised in the set of filters SR_{b}).

If the same transfer function cannot be obtained only by selecting a subset of the plurality of filters, at least one of the filters related to the first ADC (for example, the low pass filter Fltₐ) may be adapted, for instance, by modifying its parameters (via a recalibration of the filter Fltₐ), to match the transfer function at the other input terminal of the cross-check unit CC. In this way, also the data rate provided by the second ADC (via the filters up to the one having its output coupled to the cross-check unit CC) to the cross-check unit CC and the time requested for a conversion are equal between the two branches.

The modification of the parameters of the at least one filter that is to be adapted may be done via a check mode signal CM indicating that the first ADC has to operate in a synchronous mode with the second one, therefore, such check mode signal CM provides to the filter new values for the parameters that are to be modified.

Therefore, methods according to the present description may comprise an operation of matching the combination of the first analog-to-digital converter transfer function and the first filtering transfer function to the combination of the second analog-to-digital converter transfer function and the second filtering transfer function. Such operation of matching may be performed by:
selecting a subset of the first filtering unit and/or a subset of the second filtering unit to perform the respective filtering operation of the digital values; and/or
modifying, for instance, via the check mode signal CM, filtering parameters of one filtering unit between the first filtering unit and the second filtering unit.

It is noted that a combination of the ADC transfer function and the filtering transfer function is obtained by applying to the analog quantity to be measured a first processing via the ADC, thus, based on the ADC transfer function, and a further processing via the filtering unit, thus, based on the filtering transfer function.

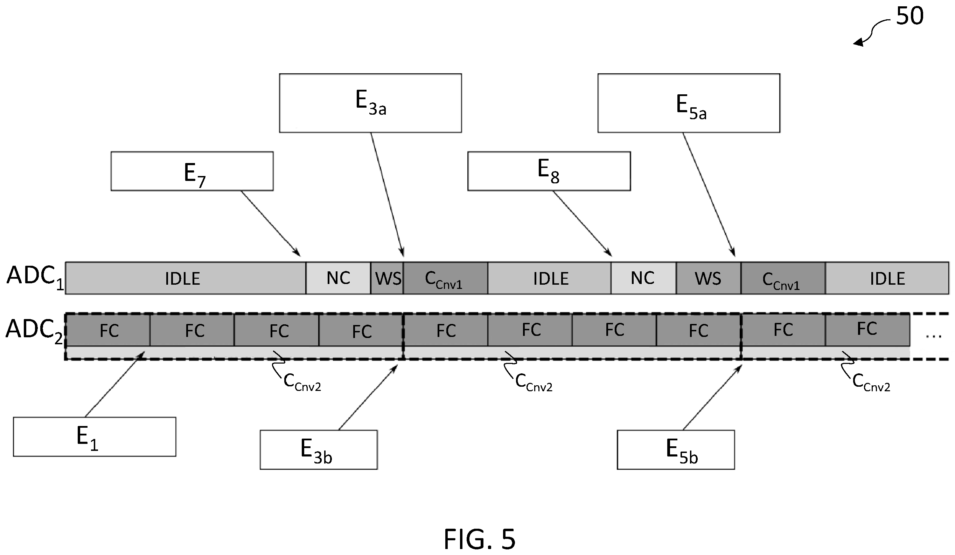

Figure 5 illustrates an exemplary diagram 50 showing the states of the first ADC₁ and the second ADC₂ analog-to-digital converters of Figure 4 according to embodiments of the present description.

Even in this case, parts, elements, and/or components which have already been described with reference to Figure 3 are denoted by the same references previously used in such figure. Therefore, the description of such previously described parts, elements, and/or components will not be repeated in the following in order not to overburden the present description.

Differently from the exemplary scenario of Figure 3, in the exemplary scenario of Figure 5, when the first ADC receives the signal from the control unit CU, for instance, in correspondence of an event E₇ or Es, such first ADC can be into a calibratable conversion mode state NC.

Therefore, in such calibratable conversion mode state NC, the parameters of the filters and their configurations are not bound to the transfer function of the second ADC, so that the control unit CU may still vary them to adapt to different scenarios.

After the calibratable conversion mode state NC, the first ADC enters in the previously described wait state WS.

Once the synchronization between the first ADC and the second ADC is obtained in correspondence of the events E₃ₐ and E_{3b} or E₅ₐ and E_{5b}, before performing the measuring operation of the first ADC, the parameters of the at least one filter that is to be adapted (related to such first ADC) are modified (in the event E₃ₐ or E₅ₐ) according to the values provided in the check mode signal CM, in order to obtain equal transfer functions before the sensing operations.

It is noted that, in embodiments according to Figure 3 or 5, the control unit, for instance, an external microcontroller, that sends the signal indicating to perform a measuring operation is to be awake in order to decide when to perform the sensing of the analog quantity for checking its correctness. If the control unit is in a sleep mode, the sensing of the analog quantity may be performed automatically, for instance, periodically, to verify the correct functioning of the sensing also during the sleep mode of the control unit.

If one of the periodic verification operations indicates that the sensing operation is not performed correctly, that is, if the absolute difference is higher than the variable digital threshold as described above, it is possible to wake-up the control unit for managing the anomaly.

Such periodic verification operation may be performed, for instance, when a timer indicates that a certain amount of time is passed from the last verification. Therefore, upon expiration of such timer, the measuring unit 10 is configured to perform a verification operation automatically, without the intervention of the control unit.

Therefore, methods as described herein may be performed in response to the reception of a command (that is, the signal indicating to perform a measuring operation described above) of a control unit CU indicating to measure the analog quantity such as the current Iₘₑₐₛ. In this case, methods as described herein may comprise:
in response to the control unit CU being in a sleep mode, automatically performing, for instance, periodically, the operation of measuring of the analog quantity, that is, the current Iₘₑₐₛ; and
if the presence of an anomaly is detected, for instance, via the cross-check unit CC, sending a wake-up signal to the control unit CU indicating said presence of the anomaly.

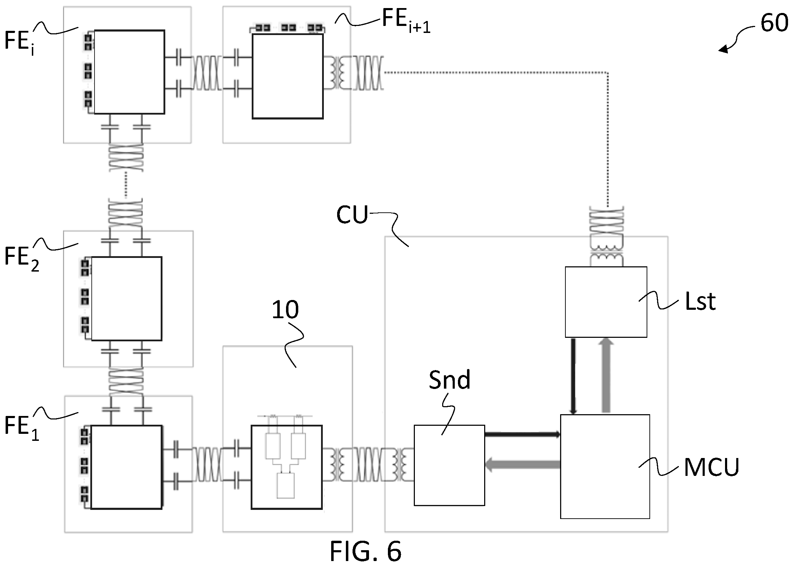

Figure 6 illustrates a BMS 60 according to embodiments of the present description.

In the BMS context, solutions as described herein may be considered to comply with the standard ISO26262, that is the international standard for functional safety of electrical and/or electronic systems that are installed in serial production road vehicles.

It is noted that BMS applications may benefit from solutions as described herein, in particular, the current sensing function in the Battery Junction Box (BJB) may benefit from the use of the measuring unit described in the foregoing.

In this regard, it is noted that:
a continuous monitoring of the battery pack current is required to estimate, via Coulomb Counting (that is, an ADC already present in the BMS configured to count the charge transferred through the battery during the charge-discharge process by monitoring the input and output current continuously), the state of charge (SOC) of such battery; and
an instantaneous monitoring of the battery pack current, for instance, via an ADC already present in the BMS, is required to perform Electrochemical Impedance Spectroscopy (EIS) or to compute the state of charge SOC by means of time-discrete estimators, such as Kalman filters.

Therefore, either the Coulomb Counter or the ADC used for the instantaneous monitoring of the battery pack current may be considered for implementing the second ADC described in the foregoing.

The BMS 60 illustrated in Figure 6 comprises the measuring unit 10 described above.

Such measuring unit 10 may be coupled to the control unit CU (for instance, comprising a microcontroller MCU) configured to send, for instance, via a sending unit Snd, the signal indicating to perform a measuring operation to the measuring unit 10. Such control unit CU may comprise also a listening unit Lst configured to receive signals, for instance, the wake-up signal described above received in case of anomaly detection during the sleep mode of the microcontroller MCU.

Such measuring unit 10 may also be coupled to a plurality of BMS front-end units FE, for example, comprising the units FE₁, FE₂, ..., FEᵢ, and FEᵢ₊₁ as illustrated in Figure 6.

Therefore, the methods according to the present description may be performed in a battery management system, BMS. In this case, the first analog-to-digital converter ADC₁ and the second analog-to-digital converter ADC₂ may be comprised in the battery management system.

To reduce the area of the die, one analog-to-digital converter between the first analog-to-digital converter ADC₁ and the second analog-to-digital converter ADC₂ may be configured to perform additional functions in the battery management system.

For instance, such analog-to-digital converter configured to perform additional functions in the battery management system may be a coulomb counter of the battery management system or an analog-to-digital converter of the battery management system configured to monitor an instantaneous battery pack current.

It is noted that solutions as described herein may be used both in time continuous and time discrete applications.

In time continuous applications, that is, applications that require continuous acquisitions of the analog quantity, partial accumulation data can be exploited to perform the conversion integrity check via the cross-check unit CC with synchronized instantaneously acquired data.

In time discrete applications, that is, applications that do not require continuous acquisitions of the analog quantity, time division multiplexing can be exploited to perform the conversion integrity check via the cross-check unit CC between (functional) converters.

Therefore, solutions as described herein facilitate obtaining a method of measuring an analog quantity such as the current Iₘₑₐₛ, increasing the reliability of such measuring.

Methods according to the present description comprise:
sensing such current Iₘₑₐₛ via a first analog-to-digital converter ADC₁ in a time instant, obtaining a first digital value;
sensing such current Iₘₑₐₛ via a second analog-to-digital converter ADC₂ in such time instant (that is, contemporaneously to the first ADC), obtaining a second digital value;
computing, for instance, via the cross-check unit CC described above, an absolute difference between the first digital value and the second digital value;
comparing, for instance, again via such cross-check unit CC, such absolute difference with a threshold, that is, the variable digital threshold described above; and
if the absolute difference is higher than the threshold, detecting the presence of an anomaly (such as an anomaly in the system or in the behavior of the analog quantity).

The threshold, that is, the variable digital threshold described above, is:
a constant value for current values below a current threshold, that is, the quantity threshold described above; and
a value that increases proportionally to the current Iₘₑₐₛ, for instance, a value that increases with the increasing of the current Iₘₑₐₛ, for current values above such current (quantity) threshold.

Thus, solutions as described herein facilitate increasing the reliability of (current) measuring operations in safety-critical (or safety-related) applications. In addition, solutions as described herein may facilitate obtaining a reduction of the area of the die requested for implementing such (current) measuring operations in safety-critical applications such as BMS applications.

In addition, solutions as described herein may present one or more of the following advantages:
reducing power consumption, since by exploiting functional structures of the BMS such as the Coulomb Counter or the ADC for the instantaneous monitoring of the battery pack current which may be used to implement the second ADC, it is not requested to supply redundant components;
reducing the die area and the related costs, again since functional structures may be exploited for implementing the second ADC, thus, redundant components are not required; and
reducing the BOM, again since functional structures may be exploited for implementing the second ADC, thus, external redundant components are not requested.

In addition, solutions according to the present description also refer to circuits 10 for measuring an analog quantity such as the current Iₘₑₐₛ, increasing the reliability of such measuring.

Circuits according to the present description comprise:
a first analog-to-digital converter ADC₁ configured to sense such current Iₘₑₐₛ in a time instant, obtaining a first digital value;
a second analog-to-digital converter ADC₂ configured to sense such current Iₘₑₐₛ in such time instant (that is, contemporaneously to the first ADC), obtaining a second digital value; and
a comparing unit (such as the cross-check unit CC described above) configured to:
   i) compute an absolute difference between the first digital value and the second digital value;
   ii) compare such absolute difference with a threshold, that is, the variable digital threshold described above; and
   iii) if the absolute difference is higher than the threshold, detect the presence of an anomaly (such as an anomaly in the system or in the behavior of the analog quantity).

Also in this case, such threshold, that is, the variable digital threshold described above, is:
a constant value for current values below a current threshold, that is, the quantity threshold described above; and
a value that increases proportionally to the current Iₘₑₐₛ, for instance, a value that increases with the increasing of the current Iₘₑₐₛ, for current values above such current (quantity) threshold.

It is noted that circuits 10 according to the present description may be comprised in a battery management system, BMS.

In this case, one analog-to-digital converter between the first analog-to-digital converter ADC₁ and the second analog-to-digital converter ADC₂ may be configured to perform additional functions in the battery management system.

For instance, the analog-to-digital converter configured to perform additional functions in the battery management system may be a coulomb counter of the battery management system or an analog-to-digital converter of the battery management system configured to monitor an instantaneous battery pack current.

In circuits 10 according to the present description, the constant value of the threshold (that is, the variable digital threshold) may be equal to the higher noise floor between the noise floor of the first analog-to-digital converter ADC₁ and the one of the second analog-to-digital converter ADC₂.

It is noted that, in circuits 10 according to the present description, the current threshold (that is, the quantity threshold) may be the current corresponding to the intersection of the higher noise floor between the noise floor of the first analog-to-digital converter ADC₁ and the one of the second analog-to-digital converter ADC₂ with an ideal error transfer function of an analog-to-digital converter.

In circuits 10 according to the present description, the first analog-to-digital converter ADC₁ and the second analog-to-digital converter ADC₂ may not be synchronous, for instance, the first analog-to-digital converter ADC₁ may have a first analog-to-digital converter transfer function and the second analog-to-digital converter ADC₂ may have a second analog-to-digital converter transfer function.

In this case, the circuit 10 may comprise:
a first filtering unit, for instance, corresponding to the plurality of cascaded filters FRₐ having a fast data rate illustrated in Figures 2 and 4, having a first filtering transfer function, configured to filter such first digital value, obtaining a first filtered digital value; and
a second filtering unit, for instance, corresponding to the plurality of cascaded filters comprising a set of filters FR_{b} having a fast data rate and a set of filters SR_{b} having a slow data rate illustrated in Figures 2 and 4, having a second filtering transfer function, configured to filter such second digital value, obtaining a second filtered digital value.

Therefore, in such a case, the comparing unit (that is, the cross-check unit CC) may be configured to compute the absolute difference between the first filtered digital value and the second filtered digital value (instead of the first digital value and the second digital value).

In addition, it is noted that in the case described above the combination of the first analog-to-digital converter transfer function and the first filtering transfer function is equal to a combination of the second analog-to-digital converter transfer function and the second filtering transfer function. Hence, the application of the first analog-to-digital converter transfer function and the first filtering transfer function to the current Iₘₑₐₛ is equal to applying the second analog-to-digital converter transfer function and the second filtering transfer function to such current Iₘₑₐₛ.

In circuits 10 according to the present description, one filtering unit between the first filtering unit and the second filtering unit may be configured to have its filtering parameters modified to make the combination of the first analog-to-digital converter transfer function and the first filtering transfer function matching the combination of the second analog-to-digital converter transfer function and the second filtering transfer function.

Similarly, a subset of the first filtering unit and/or a subset of the second filtering unit may be configured to perform the respective filtering operation on the digital values, again to make the combination of the first analog-to-digital converter transfer function and the first filtering transfer function matching the combination of the second analog-to-digital converter transfer function and the second filtering transfer function.

The circuit 10 according to solutions as described herein may be configured to be coupled to a control unit CU and to receive from such control unit CU a command indicating to measure the current Iₘₑₐₛ. In this case, the circuit 10 may be configured to:
in response to such control unit CU being in a sleep mode, automatically measure, for instance, periodically, the analog quantity such as the current Iₘₑₐₛ; and
if the presence of an anomaly is detected, for instance, by the cross-check unit CC, send a wake-up signal indicating such presence of the anomaly to the control unit CU.

In addition, it is also noted that circuits 10 as described herein may be configured to implement any other step of the method according to the present description.

Without prejudice to the underlying principles, the details and the embodiments may vary, even significantly, with respect to what has been described by way of example only without departing from the scope of the embodiments.

The extent of protection is determined by the annexed claims.

## Claims

1. Method of measuring a current (Iₘₑₐₛ), comprising:
sensing said current (Iₘₑₐₛ) via a first analog-to-digital converter (ADC₁) in a time instant, obtaining a first digital value;
sensing said current (Iₘₑₐₛ) via a second analog-to-digital converter (ADC₂) in said time instant, obtaining a second digital value;
computing (CC) an absolute difference between the first digital value and the second digital value;
comparing (CC) said absolute difference with a threshold; and
if the absolute difference is higher than the threshold, detecting the presence of an anomaly;
wherein said threshold is:
a constant value for current (Iₘₑₐₛ) values below a current threshold; and
a value that increases proportionally to the current (Iₘₑₐₛ) for current (Iₘₑₐₛ) values above said current threshold.

2. The method according to claim 1, wherein said method is performed in a battery management system, BMS, said first analog-to-digital converter (ADC₁) and said second analog-to-digital converter (ADC₂) being comprised in the battery management system.

3. The method according to claim 2, wherein one analog-to-digital converter between the first analog-to-digital converter (ADC₁) and the second analog-to-digital converter (ADC₂) is configured to perform additional functions in the battery management system;
preferably wherein said analog-to-digital converter configured to perform additional functions in the battery management system is a coulomb counter of the battery management system or an analog-to-digital converter of the battery management system configured to monitor an instantaneous battery pack current.

4. The method according to any one of the previous claims, wherein said constant value of the threshold is equal to the higher noise floor between the noise floor of the first analog-to-digital converter (ADC₁) and the one of the second analog-to-digital converter (ADC₂).

5. The method according to any one of the previous claims, wherein said current threshold is the current obtained by intersecting the higher noise floor between the noise floor of the first analog-to-digital converter (ADC₁) and the one of the second analog-to-digital converter (ADC₂) with an ideal error transfer function of an analog-to-digital converter (ADC₁; ADC₂).

6. The method according to any one of the previous claims, wherein said first analog-to-digital converter (ADC₁) and said second analog-to-digital converter (ADC₂) are not synchronous, said first analog-to-digital converter (ADC₁) having a first analog-to-digital converter transfer function and said second analog-to-digital converter (ADC₂) having a second analog-to-digital converter transfer function;
said method comprising:
filtering, via a first filtering unit (Flt_{Na}) having a first filtering transfer function, said first digital value, obtaining a first filtered digital value;
filtering, via a second filtering unit (Flt_{Mb}) having a second filtering transfer function, said second digital value, obtaining a second filtered digital value; and
performing said operation of computing (CC) the absolute difference between the first filtered digital value and the second filtered digital value;
wherein a combination of the first analog-to-digital converter transfer function and the first filtering transfer function is equal to a combination of the second analog-to-digital converter transfer function and the second filtering transfer function.

7. The method according to claim 6, comprising matching the combination of the first analog-to-digital converter transfer function and the first filtering transfer function to the combination of the second analog-to-digital converter transfer function and the second filtering transfer function by:
selecting a subset of the first filtering unit (Flt_{Na}) and/or a subset of the second filtering unit (Flt_{Mb}) to perform the respective filtering operation; and/or
modifying filtering parameters of one filtering unit between the first filtering unit (Flt_{Na}) and the second filtering unit (Flt_{Mb}).

8. The method according to any one of the previous claims, wherein said method is performed in response to the reception of a command of a control unit (CU) indicating to measure the current (Iₘₑₐₛ);
wherein said method comprises:
in response to said control unit (CU) being in a sleep mode, automatically performing, preferably periodically, the measuring of the current (Iₘₑₐₛ); and
if the presence of an anomaly is detected, sending a wake-up signal to the control unit (CU) indicating said presence of the anomaly.

9. Circuit (10) for measuring a current (Iₘₑₐₛ), comprising:
a first analog-to-digital converter (ADC₁) configured to sense said current (Iₘₑₐₛ) in a time instant, obtaining a first digital value;
a second analog-to-digital converter (ADC₂) configured to sense said current (Iₘₑₐₛ) in said time instant, obtaining a second digital value; and
a comparing unit (CC) configured to:
compute an absolute difference between the first digital value and the second digital value;
compare said absolute difference with a threshold; and
if the absolute difference is higher than the threshold, detect the presence of an anomaly;
wherein said threshold is:
a constant value for current (Iₘₑₐₛ) values below a current threshold; and
a value that increases proportionally to the current (Iₘₑₐₛ) for current (Iₘₑₐₛ) values above said current threshold.

10. The circuit (10) according to claim 9, wherein:
said constant value of the threshold is equal to the higher noise floor between the noise floor of the first analog-to-digital converter (ADC₁) and the one of the second analog-to-digital converter (ADC₂); and/or
said current threshold is the current obtained by intersecting the higher noise floor between the noise floor of the first analog-to-digital converter (ADC₁) and the one of the second analog-to-digital converter (ADC₂) with an ideal error transfer function of an analog-to-digital converter (ADC₁; ADC₂).

11. The circuit (10) according to claim 9 or claim 10, wherein said first analog-to-digital converter (ADC₁) and said second analog-to-digital converter (ADC₂) are not synchronous, said first analog-to-digital converter (ADC₁) having a first analog-to-digital converter transfer function and said second analog-to-digital converter (ADC₂) having a second analog-to-digital converter transfer function;
said circuit (10) comprising:
a first filtering unit (Flt_{Na}) having a first filtering transfer function, configured to filter said first digital value, obtaining a first filtered digital value; and
a second filtering unit (Flt_{Mb}) having a second filtering transfer function, configured to filter said second digital value, obtaining a second filtered digital value;
wherein said comparing unit (CC) is configured to compute the absolute difference between the first filtered digital value and the second filtered digital value;
wherein a combination of the first analog-to-digital converter transfer function and the first filtering transfer function is equal to a combination of the second analog-to-digital converter transfer function and the second filtering transfer function.

12. The circuit (10) according to claim 11, wherein:
one filtering unit between the first filtering unit (Flt_{Na}) and the second filtering unit (Flt_{Mb}) is configured to have its filtering parameters modified; and/or
a subset of the first filtering unit (Flt_{Na}) and/or a subset of the second filtering unit (Flt_{Mb}) is configured to perform the respective filtering operation;
to make the combination of the first analog-to-digital converter transfer function and the first filtering transfer function matching the combination of the second analog-to-digital converter transfer function and the second filtering transfer function.

13. A battery management system, BMS, including the circuit (10) according to any one of claims 9 to 12.

14. The battery management system according to claim 13, wherein one analog-to-digital converter between the first analog-to-digital converter (ADC₁) and the second analog-to-digital converter (ADC₂) is configured to perform additional functions in the battery management system;
preferably wherein said analog-to-digital converter configured to perform additional functions in the battery management system is a coulomb counter of the battery management system or an analog-to-digital converter of the battery management system configured to monitor an instantaneous battery pack current.

15. An arrangement including the circuit (10) according to any one of claims 9 to 12 and a control unit (CU), wherein said circuit (10) is coupled to said control unit (CU) and configured to receive from said control unit (CU) a command indicating to measure the current (Iₘₑₐₛ);
wherein said circuit (10) is configured to:
in response to said control unit (CU) being in a sleep mode, automatically measure, preferably periodically, the current (Iₘₑₐₛ); and
if the presence of an anomaly is detected, send a wake-up signal indicating said presence of the anomaly to the control unit (CU).
